# EUROPÄISCHE PATENTSCHRIFT

(11) **EP 3 846 344 B1**
(45) Veröffentlichungstag und Bekanntmachung des Hinweises auf die Patenterteilung: **22.07.2026**
(21) Anmeldenummer: 20216105.5
(22) Anmeldetag: 21.12.2020
(51) Int. Cl.: H03K 17/687, H03K 17/16

(54) **INTELLIGENTER TASTER FÜR EINE GEBÄUDEINSTALLATION**
SMART BUTTON FOR BUILDING INSTALLATION
BOUTON INTELLIGENT POUR UNE INSTALLATION DE BÂTIMENT

(30) Priorität: 30.12.2019 CH 17112019
(43) Veröffentlichungstag der Anmeldung: 07.07.2021
(73) Patentinhaber: Iolo AG, 3280 Murten (CH)
(72) Erfinder: STRAUMANN, Reto, 3280 Murten (CH); GRUENIG, Stefan, 3098 Köniz (CH); KIENLE, Thomas, 3052 Zollikofen (CH)
(74) Vertreter: Prins Intellectual Property AG

(56) Entgegenhaltungen:
- EP-A1- 0 515 961
- EP-A1- 2 945 288
- EP-A2- 2 081 296
- EP-B1- 2 081 296
- EP-B1- 2 945 288
- DE-A1- 102014 210 000
- US-A- 5 712 558
- LASZLO BALOGH: "Fundamentals of MOSFET and IGBT Gate Driver Circuits, Application Report SLUA618A", 15 October 2018 (2018-10-15), Dallas, Texas, USA, pages 1 - 48, XP055622268, Retrieved from the Internet <URL:http://www.ti.com/lit/ml/slua618a/slua618a.pdf> [retrieved on 20190913]

## Beschreibung

### Technisches Gebiet

Die Erfindung betrifft einen Taster für eine Gebäudeinstallation. Insbesondere betrifft die Erfindung einen intelligenten Taster für eine Gebäudeinstallation.

### Technischer Hintergrund

Schalter und Taster für Gebäudeinstallationen werden für das Ein-/Ausschalten und für das Steuern von elektrischen Geräten eingesetzt. Eine Gebäudeinstallation umfasst elektrische Zuleitungen, insbesondere mit Nullleiter und Aussenleiter (Phase), welche in Wohnungen, Häusern, Büroräumlichkeiten, etc. elektrische Energie zur Verfügung stellen, wobei Unter- oder Aufputzdosen vorbereitet sind für Schalter und Taster, mit welchen elektrische Geräte ein-/ausgeschaltet und gesteuert werden können. Elektrische Geräte umfassen elektrische Lichtquellen, elektrische Motoren von Jalousien, Storen, Rollläden, Beschattungsanlagen, etc., Thermostaten, Heizungsventile, etc. Während ein Schalter nur das Ein- oder Ausschalten eines elektrischen Geräts ermöglicht, also beispielsweise das Ein- oder Ausschalten einer elektrischen Lichtquelle, können mit sogenannten intelligenten Tastern zusätzlich weitergehende Funktionen zur Verfügung gestellt werden, wie beispielsweise das Dimmen einer dimmbaren Lichtquelle, das (programmierte) Steuern einer Store bis zum Erreichen einer vorgegebenen Position (beispielsweise mit geöffneten Lamellen), das Einstellen einer Solltemperatur, etc.. Intelligente Taster können Bewegungssensoren, Helligkeitssensoren, Temperatursensoren, etc. umfassen, wobei beispielsweise die Helligkeit einer dimmbaren Lichtquelle automatisch an die momentan vom Helligkeitssensor erfasste Helligkeit angepasst wird. Intelligente Taster können zudem in verschiedene drahtlose Netzwerke eingebunden sein, wie beispielsweise in drahtlose Netzwerke gemäss einem IEEE-802.11-Standard, einem Bluetooth Standard, einem Bluetooth Low Energy Standard, einem ZigBee Standard, einem Z-Wave Standard, etc., um beispielsweise die Bedienung, Programmierung, etc. mit einem Smartphone zu ermöglichen oder eine Einbindung in ein Smart Home Netzwerk zu ermöglichen.

Schalter und Taster für Gebäudinstallationen können in vorgegebenen Grössen hergestellt sein, sodass der Einbau eines Schalters oder Tasters respektive das Austauschen beispielsweise eines bestehenden Schalters durch einen Taster ohne Änderungen an bestehenden Unter- oder Aufputzdose gewährleistet sind. Dem Elektroinstallationsfachmann sind sogenannte "1er Einbaudosen" bekannt, welche einen Durchmesser von maximal 62mm und eine Einbautiefe von maximal 52mm aufweisen und Schalter und Taster mit diesen maximalen Massen aufnehmen können, oder mit kleineren Massen wie beispielsweise einen Durchmesser von 60mm und einer Einbautiefe von 32mm oder 45mm. Taster werden in unterschiedlichsten Ausführungsformen hinsichtlich Funktionen der Taster hergestellt, beispielsweise in Ausführungsformen zum Dimmen von elektrischen Lampen, oder in Ausführungsformen zum Steuern eines elektrischen Motors wie einem Storenmotor, oder in Ausführungsformen die nur einen Sensor umfassen, etc. Solche unterschiedliche Ausführungsformen werden vom Elektroinstallationsfachmann auch als sogenannte Aktoren oder Sensoren bezeichnet. Bei der Installation solcher Taster müssen dem Elektroinstallationsfachmann somit Taster in unterschiedlichsten Ausführungsformen zur Verfügung gestellt werden, d.h. Taster in der Form eines Aktors, eines Sensors, etc. Dies erfordert einen entsprechenden logistischen Aufwand, da Taster in unterschiedlichsten Ausführungsformen bereitgestellt werden müssen, was insbesondere auf Baustellen von neu erstellten Gebäuden unerwünscht sein kann. Werden Taster in Mietwohnungen durch den Mieter selber installiert, dann ist bei einem Umzug nicht gewährleistet, dass die Funktionen der Taster des Mieters an die neue Mietwohnung angepasst sind, beispielsweise falls die neue Wohnung zwar dieselbe Anzahl Unterputz- oder Aufputzdosen aufweist und somit der Mieter zwar alle bestehenden Taster weiter verwenden kann, diese aber eine andere Anzahl dimmbare Lichtquellen, elektrisch steuerbare Storen, oder Thermostaten/Heizungsventile anzupassen sind. Dies führt zu entsprechendem Elektroschrott, welcher unerwünscht sein kann.

DE102014210000 zeigt Verfahren zur Vorortinteraktion (z.B. für Vorortbedienung, Wartung, Fehlerdiagnose, Konfiguration) mit einem Busgerät eines Gebäudeautomatisierungssystems, wobei eine bidirektionale Kommunikationsverbindung zwischen einem mobilen Kommunikationsendgerät (z.B. Smartphone) eines Benutzers (z.B. Installateur) mit einem Busgerät hergestellt wird.

EP2081296 zeigt einen elektrischen Installationsschalter bestehend aus einem Unterteil und aus einem relativ zum Unterteil bewegbaren Bedienelement, wobei das Unterteil mehrere von dem Bedienelement zu betätigende Schaltelemente zum Herstellen eines elektrischen Kontaktes und weitere elektrische Bauteile aufweist. Um einen elektrischen Installationsschalter zu schaffen, der multifunktional und flachbauend ausgebildet ist, sind die Schaltelemente Druckkraft messende Sensoren und ist das Bedienelement schwimmend auf dem Unterteil angeordnet.

EP2945288 sieht vor, um die Probleme mit steilflankigen Steuerspannungen von Halbleiterschaltelementen zu reduzieren, dass der Steueranschluss des Halbleiterschaltelements über eine Rampenerzeugungseinheit mit dem Ausgangsanschluss des Halbleiterschaltelements verbunden ist und die Rampenerzeugungseinheit zur Erzeugung einer Transistor-Steuerspannung am Ausgang der Rampenerzeugungseinheit die steil steigenden und fallenden Flanken der Treiber-Steuerspannung rampenförmig abflacht.

EP0515961 zeigt zur Steuerung eines einer Last zuzuführenden Wechselstromes steuerbare Halbleiter, die in der Regel am Gleichspannungsausgang einer Gleichrichterbrücke liegen, so dass der Laststrom jeweils zwei Gleichrichterdioden und den steuerbaren Halbleiter durchfließen muss, bevor er die Last erreicht. Es soll eine Schaltung geschaffen werden, die mit geringerer Verlustleistung auskommt. Als steuerbare Halbleiter dienen zwei mit ihren Schaltstrecken in Reihe liegende Transistoren, wobei jeder Schaltstrecke eine Inversdiode parallelgeschaltet ist. Die beiden Transistoren sind so gepolt und gesteuert, dass jede der beiden Halbwellen des Wechselstroms nur eine Inversdiode und eine Schaltstrecke auf dem Weg zur Last durchfließen muss. Die Schaltung soll bevorzugt bei Dimmern zur Anwendung kommen.

US5712558 zeigt ein optisch gesteuertes Dimmergerät, mit dem die Helligkeit einer Glühlampe reguliert werden kann. Das Gerät kann auch zur Steuerung anderer elektrischer Verbraucher wie z. B. Wechselstrom verwendet werden. Typ Motoren. Eines der Hauptmerkmale des Geräts ist, dass es optisch gesteuert werden kann. Das Gerät umfasst eine lichtemittierende Komponente, die dazu geeignet ist, Licht zu emittieren, und eine lichtempfangende Komponente, die so positioniert ist, dass sie das von einem Objekt reflektierte Licht von der lichtemittierenden Komponente empfängt und dadurch ein Ausgangssignal erzeugt. Eine Verarbeitungsschaltung einschließlich einer Phasenverschiebungsschaltung ist operativ mit der Lichtempfangskomponente verbunden. Die Verarbeitungsschaltung ist dazu ausgelegt, das Ausgangssignal zu empfangen und das Ausgangssignal zu verarbeiten und dadurch die Leistungsabgabe an die elektrische Last zu regeln.

### Darstellung der Erfindung

Eine Aufgabe der Erfindung ist es, zumindest gewisse Nachteile des Standes der Technik zu überwinden. Es ist insbesondere eine Aufgabe der Erfindung einen Taster für Gebäudeinstallationen zur Verfügung zu stellen, welcher insbesondere den logistischen Aufwand minimiert bei Neuinstallationen oder Elektroschrott vermeidet bei Mieter- oder Besitzerwechsels eines Gebäudes oder eines Gebäudeteils wie einer Wohnung, eines Geschäftsbüros, etc.

Diese Aufgaben werden gelöst durch einen Taster mit den Merkmalen des unabhängigen Anspruchs. Vorteilhafte Ausführungsformen des Tasters ergeben sich aus den Merkmalen der abhängigen Ansprüche.

Ein erfindungsgemässer Taster für eine Gebäudeinstallation weist eine für die Gebäudeinstallation geeignete vorgegebene Grösse auf und elektrische Anschlüsse auf, an welche wahlweise eine elektrische Lichtquelle oder ein elektrischer Motor anschliessbar sind, wobei der Taster ausgebildet ist zum Ein-/Ausschalten und allenfalls Dimmen der anschliessbaren Lichtquelle und zum Betreiben des anschliessbaren elektrischen Motors. Der erfindungsgemässe Taster ist geeignet, den logistischen Aufwand bei Neuinstallationen zu minimieren und Elektroschrott zu vermeiden, da ein einziger Typ Taster genügt, um sowohl das Ein-/Ausschalten bzw. Dimmen von Lichtquellen als auch das Betreiben von elektrischen Motoren zu ermöglichen.

Erfindungsgemäß ist die vorgegebene Grösse definiert durch einen maximalen Durchmesser von 62mm und eine maximale Einbautiefe von 52mm. Der Taster ist somit geeignet für dem Elektroinstallationsfachmann bekannte sogenannte "1er Einbaudosen". In einer Ausführungsform bezieht sich die elektrische Lichtquelle auf eine nur schaltbare Lichtquelle oder auf eine sowohl schaltbare als auch dimmbare Lichtquelle. Die nur schaltbare Lichtquelle kann sich auf eine Lichtquelle mit Vorschaltgerät beziehen. Die dimmbare Lichtquelle kann sich auf eine dimmbare Lampe, Leuchte, jeweils mit oder ohne Vorschaltgerät, etc. beziehen. Der Taster ist geeignet, um bekannte Lichtquellen ein-/auszuschalten bzw. zu dimmen.

In einer Ausführungsform bezieht sich der elektrische Motor auf einen elektrischen Motor für den Antrieb von Storen, von Jalousien, von Sonnenstoren, von Rollläden, von Fensterläden, von Beschattungsanlagen, von Toren, von Türen und/oder von Fenstern. Der Taster ist geeignet, um induktive Lasten direkt zu betreiben. Der Taster ist geeignet, um bekannte elektrische Motoren direkt zu betreiben.

In einer Ausführungsform ist ein Heizungsventil an die elektrischen Anschlüsse anschliessbar und der Taster ist ausgebildet, dem anschliessbaren Heizungsventil einen Thermostaten zur Verfügung zu stellen. Der Taster kann einen Thermostaten ersetzen und der logistische Aufwand kann weiter minimiert werden bzw. der Elektroschrott weiter vermieden werden.

In einer Ausführungsform umfasst der Taster einen programmierten Mikroprozessor. Der programmierte Mikroprozessor kann unterschiedliche Funktionen zur Verfügung stellen, wie beispielsweise die Automatisierung der Steuerung von elektrischen Geräten.

In einer Ausführungsform umfasst der Taster eine drahtlose Schnittstelle gemäss einem IEEE-802.11-Standard, einem Bluetooth Standard, einem Bluetooth Low Energy Standard, einem ZigBee Standard, und/oder einem Z-Wave Standard. Der Taster kann auch andere drahtlose Schnittstellen umfassen. Mit einem Smartphone können am Taster Einstellungen oder Programmierungen vorgenommen werden oder der Taster kann in ein Smart-Home Netzwerk eingebunden werden.

In einer Ausführungsform umfasst der Taster einen Bewegungssensor, einen Helligkeitssensor, einen Temperatursensor, einen Luftqualitätssensor, einen Feuchtigkeitssensor und/oder einen Lautstärkesensor. Funktionen des Tasters sind an aktuelle Umgebungswerte anpassbar.

Erfindungsgemäß weist der Taster mindestens einen MOSFET auf welcher eingerichtet ist, um wahlweise mindestens eine Lichtquelle ein-/auszuschalten und allenfalls zu dimmen und mindestens einen elektrische Motor in mindestens einer Richtung zu betreiben (MOSFET: Metal-Oxide-Semiconductor Field-Effect Transistor). In einer Ausführungsform weist der Taster insgesamt acht MOSFET auf die eingerichtet sind, um wahlweise bis zu vier Lichtquellen ein-/auszuschalten und allenfalls zu dimmen und bis zu zwei elektrische Motoren zu betreiben. Die MOSFET können paarweise angeordnet sein für den Anschluss von Wechselstromlichtquellen. Es können ferner bis zu vier Heizungsventile angeschlossen werden.

Erfindungsgemäß ist für mindestens einen MOSFET eine Treiberstufe vorgesehen, die Treiberstufe umfassend: entweder eine Parallelschaltung mit einem ersten Kondensator und einem ersten Widerstand welche zwischen der Basis eines bipolaren Transistors und dem Gate des MOSFET angeschlossen ist, eine Parallelschaltung mit einem zweiten Kondensator und einem zweiten Widerstand welche zwischen der Basis des bipolaren Transistors und der Source des MOSFET angeschlossen ist, wobei der Emitter des bipolaren Transistors am Gate des MOSFET angeschlossen ist, wobei der Kollektor des bipolaren Transistors über einen dritten Widerstand an der Source des MOSFET angeschlossen ist, und einen vierten Widerstand welcher zwischen Gate und Source des MOSFET angeschlossen ist, oder die Treiberstufe umfasst einen programmierten Mikro-Controller, der derart eingerichtet, dass durch Ansteuerung des Ausgangs des Mikro-Controllers der MOSFET (Q1) programmiert verriegelbar ist, wobei ein bipolarer NPN Transistor (T1') dessen Basis an einen Ausgang (OFF) des Mikro-Controllers angeschlossen ist, wobei der Emitter des bipolaren Transistors (T1') am Gate (G) des MOSFET (Q1) angeschlossen ist, wobei der Kollektor des bipolaren Transistors (T1') über einen dritten Widerstand (R3) an der Source (S) des MOSFET (Q1) angeschlossen ist, und ein vierter Widerstand (R4) zwischen Gate (G) und Source (S) des MOSFET angeschlossen ist. Die Treiberstufe ermöglicht sowohl das Dimmen von dimmbaren Lichtquellen als auch das Betreiben von elektrischen Motoren, wobei der Taster in einer für eine Gebäudeinstallation geeigneten vorgegebenen Grösse herstellbar ist und somit ein Taster zur Verfügung gestellt ist, mit welchem logistischer Aufwand minimiert werden kann und Elektroschrott vermieden werden kann.

In einer Ausführungsform ist das Gate über einen fünften Widerstand, eine erste Diode in Sperrrichtung, eine zweite Diode in Durchlassrichtung und über die Parallelschaltung mit dem ersten Kondensator und dem ersten Widerstand mit der Basis des bipolaren Transistors verbunden.

In einer Ausführungsform ist die Treiberstufe angepasst für die Ansteuerung durch einen Mikro-Controller.

In einer Ausführungsform umfasst der Taster weiter eine Ansteuerschaltung zur Erzeugung einer Gate-Source Spannung für mindestens einen MOSFET, die Ansteuerschaltung umfassend: eine Diode welche im Zusammenwirken mit einer Body-Diode des mindestens einen MOSFET eine gleichgerichtete Spannung zur Ansteuerung eines Linearreglers erzeugt, wobei der Linearregler eine Spannung zur Ansteuerung des mindestens einen MOSFET zur Verfügung stellt. Die Ansteuerschaltung hat eine kompakte Grösse und der Taster ist in einer für eine Gebäudeinstallation geeigneten vorgegebenen Grösse herstellbar. Somit ist ein Taster zur Verfügung gestellt, mit welchem logistischer Aufwand minimiert werden kann und Elektroschrott vermieden werden kann.

### Kurze Erläuterung zu den Figuren

Die Erfindung soll nachfolgend anhand von Ausführungsbeispielen im Zusammenhang mit der(n) Zeichnung(en) näher erläutert werden. Es zeigen:
- Fig. 1: eine schematische Explosionsdarstellung der Vorderseite eines erfindungsgemässen Tasters;
- Fig. 2: eine schematische Explosionsdarstellung der Hinterseite eines erfindungsgemässen Tasters;
- Fig. 3: eine schematische Aufsicht auf ein hinteres Abdeckungsteil eines Basisteils eines erfindungsgemässen Tasters;
- Fig. 4: eine schematisch eine Vorderansicht eines erfindungsgemässen Tasters;
- Fig. 5: eine schematische Darstellung einer Treiberschaltung für MOSFET;
- Fig. 5a: eine schematische Darstellung einer Ausführungsform einer Treiberschaltung für MOSFET;
- Fig. 5b: eine schematische Darstellung einer Ausführungsform einer Treiberschaltung für MOSFET; und
- Fig. 6: eine schematische Darstellung einer Gatespannungsversorgung für MOSFET.

### Wege zur Ausführung der Erfindung

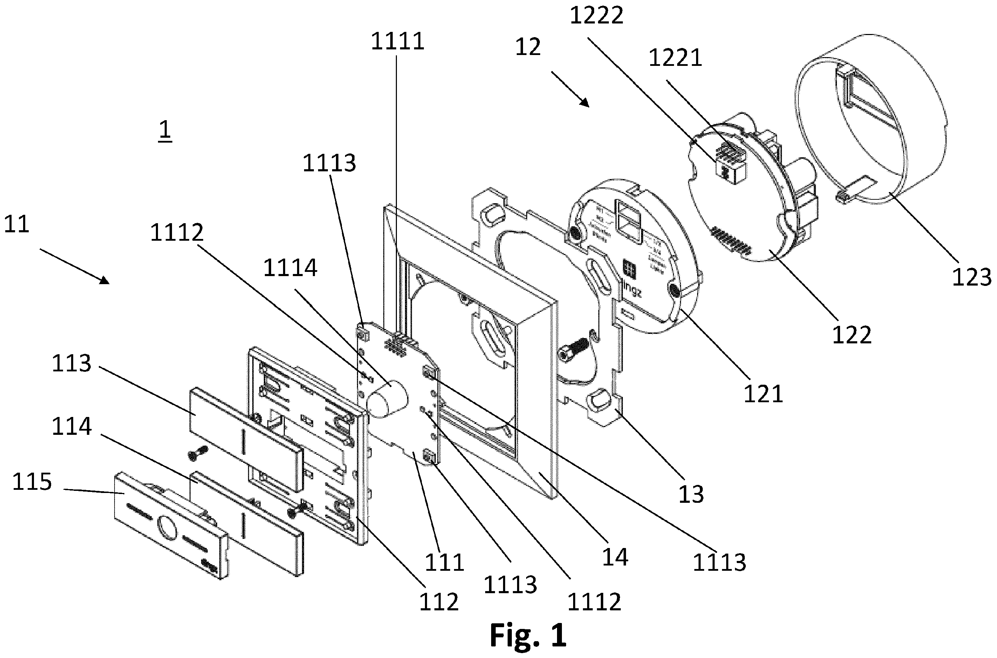

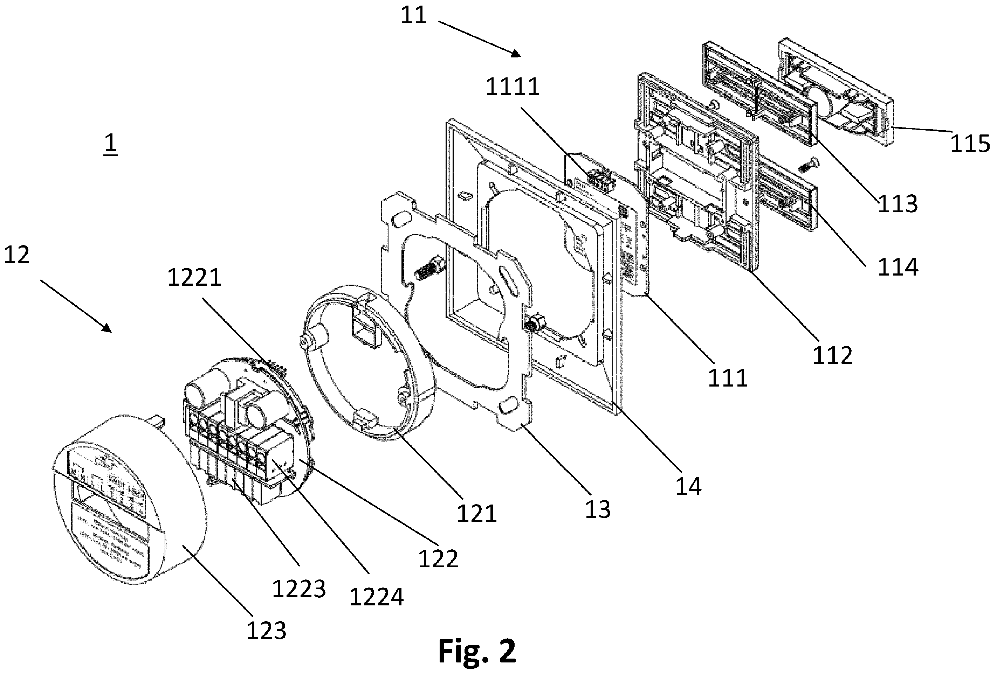

Figur 1 zeigt eine schematische Explosionsdarstellung der Vorderseite eines erfindungsgemässen Tasters 1. Figur 2 zeigt eine schematische Explosionsdarstellung der Hinterseite des erfindungsgemässen Tasters 1.

Wie in den Figuren 1, 2 schematisch dargestellt, umfasst der Taster 1 ein Frontteil 11 sowie ein Basisteil 12, welche an einem Befestigungsteil 13 angebracht werden können, beispielsweise damit verschraubt werden können. Das Befestigungsteil 13 kann an einer Gebäudewand befestigt werden, beispielsweise damit verschraubt werden. Eine Abdeckung 14 kann am Befestigungsteil 13 angebracht werden. Die Abdeckung 14 kann einen mechanischen und/oder elektrischen Schutz, eine optisch ansprechende Ausgestaltung, etc. zur Verfügung stellen. Der Taster 1 ist für eine Unterputzmontage ausgebildet. Der Taster 1 kann für die Aufputzmontage ausgebildet sein (nicht gezeigt in Figuren 1, 2), wobei beispielsweise eine entsprechend ausgebildete Abdeckung 14 vorgesehen sein kann.

Das Frontteil 11 des Tasters 1 umfasst eine vordere PCB Anordnung 111 (PCB: Printed Circuit Board), welche elektronische und elektrische Bauteile aufweist. Die vordere PCB Anordnung 111, welche nachfolgend als vorderes PCB 111 bezeichnet wird, kann eine oder mehrere PCB, d.h. eine oder mehrere Platinen, aufweisen. Die elektronischen und elektrischen Bauteile des vorderen PCB 111 umfassen insbesondere eine elektrische Schnittstelle 1111 zur Verbindung mit einem nachfolgend erläuterten hinteren PCB 121, eine drahtlose Schnittstelle gemäss einem IEEE-802.11-Standard, mehrere LED 1112 (LED: Light Emitting Diodes), mehrere Drucktaster 1113, etc.. Die elektronischen und elektrischen Bauteile des vorderen PCB 111 können einen Bewegungssensor 1114, einen Temperatursensor, und/oder einen Helligkeitssensor umfassen. Das Frontteil 11 des Tasters 1 umfasst einen vorderen Rahmen 112, an welchem Tasterabdeckungen 113, 114 angebracht werden können, beispielsweise form- und/oder kraftschlüssig, für die Betätigung von auf dem vorderen PCB 111 angebrachte Drucktaster 1113. Das vordere PCB 111 umfasst vier Drucktaster 1113, wovon in Figur 1 drei sichtbar sind, welche durch Drücken auf entsprechende Bereiche der Tasterabdeckungen 113, 114 betätigt werden können, d.h. durch Drücken dieser Bereiche können die Drucktaster 1113 kurz (z.B. weniger als 2 Sekunden) oder länger (z.B. mehr als 2 Sekunden) geschlossen werden. Es können mehr oder weniger als vier Druckschalter angeordnet sein. Es können andere Druckmuster wie beispielsweise ein Doppelklick vorgesehen sein. Das vordere PCB 111 kann am vorderen Rahmen 112 angebracht sein, beispielsweise damit verschraubt sein. Der vordere Rahmen 112 kann an dem nachfolgend näher beschriebenen Basisteil 12 angebracht sein, beispielsweise damit verschraubt sein. Am vorderen Rahmen 112 kann eine vordere Abdeckung 115 (PIR Passive InfraRed) angebracht sein. Die vordere Abdeckung 115 umfasst Mittel zur Durchführung des Bewegungssensors 1112, insbesondere eine entsprechende Öffnung, und optische Mittel, insbesondere optische Leiter, um dem Benutzer das von den LED 1112 des vorderen PCB 111 ausgestrahlte Licht sichtbar zu machen. Die LED 1112 können ausgebildet sein, um Licht in unterschiedlichen Farben auszustrahlen, also z.B. weisses, blaues, rotes, grünes, etc. Licht.

Das Basisteil 12 des Tasters 1 umfasst eine hintere PCB Anordnung 122, welche elektronische und elektrische Bauteile aufweist. Die hintere PCB Anordnung 122, welche nachfolgend als hinteres PCB 122 bezeichnet wird, kann ein oder mehrere PCB, d.h. eine oder mehrere Platinen, aufweisen. Die elektronischen und elektrischen Bauteile des hinteren PCB 122 umfassen insbesondere eine elektrische Schnittstelle 1221 zur Verbindung mit dem vorderen PCB 111, mehrere DIP Schalter 1222 (DIP: Dual In-line Package), mehrere MOSFET 1223 (MOSFET: Metal-Oxide-Semiconductor Field-Effect Transistor), und mehrere elektrische Anschlussbuchsen 1224 zur Verbindung mit elektrischen Gebäudeleitungen und elektrischen Geräten. Das Basisteil 12 umfasst ein hinteres Abdeckungsoberteil 121 und ein hinteres Abdeckungsunterteil 123, welche miteinander verbindbar sind und das hintere PCB 122 aufnehmen können.

Das Frontteil 11 und/oder das Basisteil 12 weisen einen oder mehrere Mikroprozessoren auf, welche programmiert sind für die Ausführung von erforderlichen Funktionen des Tasters 1.

Das Basisteil 12 weist einen maximalen Durchmesser von 62mm auf und eine maximale Einbautiefe von 52mm. In einer Ausführungsform weist das Basisteil 12 einen Durchmesser auf von 60mm auf und eine Einbautiefe von 45mm oder 32mm. Der Taster ist somit geeignet für den Einbau in sogenannte "1er Einbaudosen", welche dem Elektroinstallationsfachmann bekannt sind.

Am Taster 1 können Leuchten, elektrische Motoren, Storen und Heizungsventile angeschlossen werden und mit dem Taster 1 bedient werden. Der Taster 1 kann ausgebildet bzw. programmiert sein, um im Zusammenwirken mit dem integrierten Bewegungssensor 1114 und Helligkeitssensor das Licht automatisch sanft ein- und auszudimmen, beispielsweise für eine vorgegebene Zeitperiode wie beispielsweise drei Minuten. Der Taster 1 kann ausgebildet sein, um einen abgesetzten Taster oder Bewegungsmelder anzuschliessen. Der Taster 1 kann ausgebildet bzw. programmiert sein, um die Einrichtung von Funktionen mit einem Smartphone vorzunehmen. Der Taster 1 kann ausgebildet bzw. programmiert sein, um in ein Smart-Home Netzwerk eingebunden zu werden. Der Taster 1 kann ausgebildet bzw. programmiert sein, um mit einem kurzen Tastendruck eine Leuchte ein- oder auszuschalten, mit einem ersten langen Tastendruck die Leuchte hochzudimmen, mit einem weiteren langen Tastendruck die Leuchte wieder runterzudimmen. Die Bezeichnung "kurz drücken" kann bedeuten, dass der Tastendruck weniger als 2 Sekunden dauert und die Bezeichnung "lang drücken" kann bedeuten, dass der Tastendruck mehr als 2 Sekunden dauert. Der Taster 1 kann ausgebildet bzw. programmiert sein, um mit einem kurzen Tastendruck eine Jalousie/Store in die obere oder untere Endposition zu fahren, mit eine kurzen Tastendruck während der Fahrt die Jalousie/Store zu stoppen, mit einem doppelten Tastendruck die Jalousie ganz herunterzufahren und die Lamellen zu öffnen, mit einem langen Tastendruck die Store in kurzen, präzisen Schritten zu bewegen. Der Taster 1 kann ausgebildet bzw. programmiert sein, um auf Druck auf eine als Thermostattaste programmierte Taste die Raumtemperatur mittels LEDs anzuzeigen (beispielsweise dreimaliges blau blinken bei 17°C, zweimaliges blau blinken bei 18°C, einmaliges blau blinken bei 19°C, einmaliges grün blinken bei 20°C, einmaliges rot blinken bei 21°C, zweimaliges rot blinken bei 22°C, dreimaliges rot blinken bei 23°C, etc.), und durch anschliessendes Drücken einer vorgegebenen Taste die Solltemperatur zu erhöhen oder zu verringern (beispielsweise in Stufen von 1°C). Der Taster 1 kann ausgebildet bzw. programmiert sein, um durch langsames oder schnelles Blinken oder durch konstantes Leuchten der LEDs je nach Farbe Statusinformationen betreffend WLAN Modus (WLAN: Wireless Local Area Network), Reset, Firmwareaktualisierung, Übertemperatur, etc. anzuzeigen. Der Taster 1 kann ausgebildet bzw. programmiert sein, um eine Konfigurationsanpassung mittels zwei DIP Schalter vorzunehmen, beispielsweise den ersten und zweiten DIP Schalter in Position rechts für eine Konfiguration für vier Leuchten, den ersten DIP Schalter in Position rechts respektive links und den zweiten DIP Schalter in Position links respektive rechts für eine Konfiguration für den Betrieb mit zwei Leuchten und einer Jalousie/Store, und den ersten und zweiten DIP Schalter in Position links eine Konfiguration für den Betrieb mit zwei Jalousien/Storen. Der Taster 1 weist Anschlüsse auf für den Anschluss an Aussenleiter (Phase) und Neutralleiter von elektrischen Zuleitungen einer Gebäudeinstallation.

Bei der Installation in einem Gebäude ist der Taster 1 für unterschiedlichste Aufgaben geeignet. Insbesondere können mit dem Taster 1 sowohl Lichtquellen ein-/ausgeschaltet bzw. gedimmt werden als auch elektrische Motoren von Jalousien/Storen, Türen, Tore, Fenster, etc. betrieben werden. Es müssen somit nicht unterschiedliche Ausführungsformen von Tastern für unterschiedliche Aufgaben wie bei herkömmlichen Tastern zur Verfügung gestellt werden. Bei der Installation von erfindungsgemässen Tastern in Gebäuden kann der logistische Aufwand minimiert werden, da es genügt den Taster in der beschriebenen einzigen Ausführungsform zur Verfügung zu stellen. Bei einem Mieter- oder Besitzerwechsel können bestehende Taster auch in einem anderen Gebäude weiterverwendet werden und Elektroschrott kann vermieden werden.

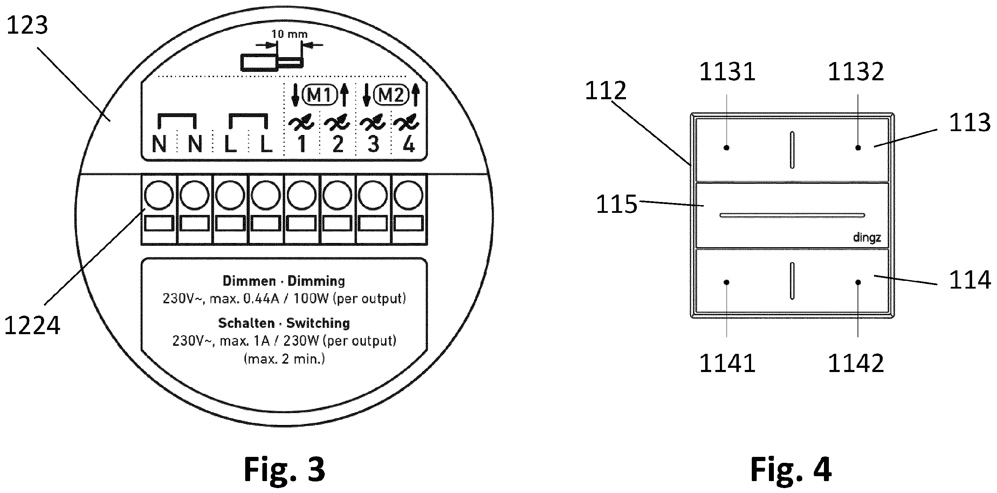

Figur 3 zeigt schematisch eine Aufsicht auf das hintere Abdeckungsteil 123 des Basisteils 12 des erfindungsgemässen Tasters 1. Das hintere Abdeckungsteil 123 umfasst Mittel, insbesondere Öffnungen, zur Durchführung der mehreren Anschlussbuchsen 1224 des hinteren PCB 122. Ferner umfasst das hintere Abdeckungsteil 123 eine Kennzeichnung der betreffenden mehreren Anschlussbuchsen 1224. Wie in Figur 3 illustriert, können zwei Anschlussbuchsen 1224 vorgesehen sein für den Anschluss an Neutralleiter N von elektrischen Zuleitungen einer Gebäudeinstallation, zwei Anschlussbuchsen können vorgesehen sein für den Aussenleiter (Phase) L der elektrischen Zuleitungen einer Gebäudeinstallation, und vier Anschlussbuchsen, welche mit 1, 2, 3, 4 bzw. mit M1, M2 nummeriert sind, können vorgesehen sein, um wahlweise bis zu vier elektrische Lichtquellen und bis zu zwei elektrische Motoren sowie Kombinationen aus elektrischen Lichtquellen und elektrischen Motoren anzuschliessen. Die vier mit 1, 2, 3, 4 bzw. mit M1, M2 nummerierten Anschlussbuchsen können ferner für den Anschluss an ein Heizungsventil, eine Heizungssteuerung, etc. vorgesehen sein.

Figur 4 zeigt schematisch eine Vorderansicht des erfindungsgemässen Tasters 1 und die Zuordnung der Tasterabdeckungen 113, 114 respektive der Bereiche 1131, 1132, 1141, 1142 für die Betätigung der Drucktaster 1113 des vorderen PCB 111. Der Bereich 1131 kann der Anschlussbuchse 1224 mit der Nummerierung 1 zugeordnet sein. Der Bereich 1132 kann der Anschlussbuchse 1224 mit der Nummerierung 2 zugeordnet sein. Der Bereich 1141 kann der Anschlussbuchse 1224 mit der Nummerierung 3 zugeordnet sein. Der Bereich 1142 kann der Anschlussbuchse 1224 mit der Nummerierung 4 zugeordnet sein. Andere Zuordnungen sind möglich, insbesondere mittels des programmierten Mikroprozessors. Somit kann mit dem Bereich 1131 ein erste Lichtquelle ein-/ausgeschaltet oder gedimmt werden, mit dem Bereich 1132 kann eine zweite Lichtquelle ein-/ausgeschaltet oder gedimmt werden, mit dem Bereich 1141 kann eine dritte Lichtquelle ein-/ausgeschaltet oder gedimmt werden, mit dem Bereich 1142 kann eine vierte Lichtquelle ein-/ausgeschaltet oder gedimmt werden. Je nach Konfiguration des Tasters 1 kann mit dem Bereich 1131 ein erster elektrischer Motor in einer ersten Richtung betrieben werden und mit dem Bereich 1132 in einer zweiten Richtung betrieben werden, und es kann mit dem Bereich 1141 ein zweiter elektrischer Motor in einer ersten Richtung betrieben werden und mit dem Bereich 1142 in einer zweiten Richtung betrieben werden. Andere Zuordnungen sind möglich, insbesondere mittels des programmierten Mikroprozessors.

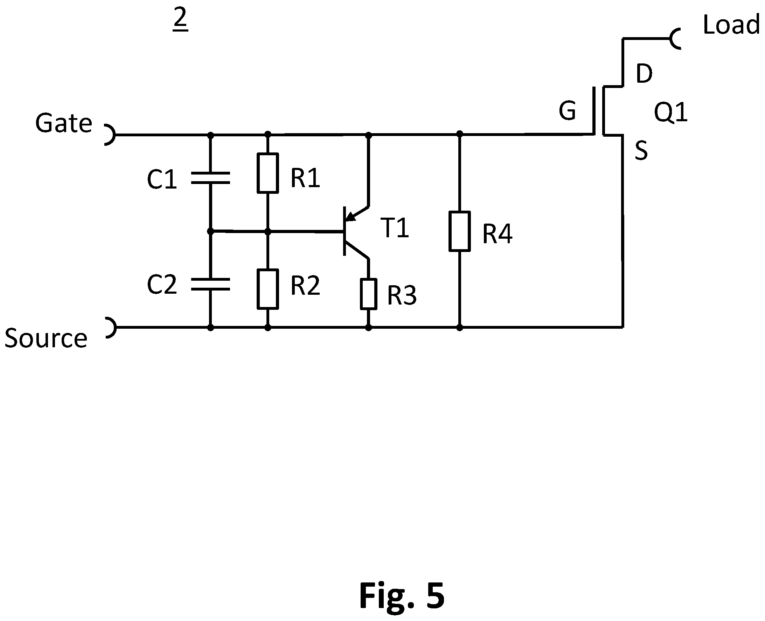

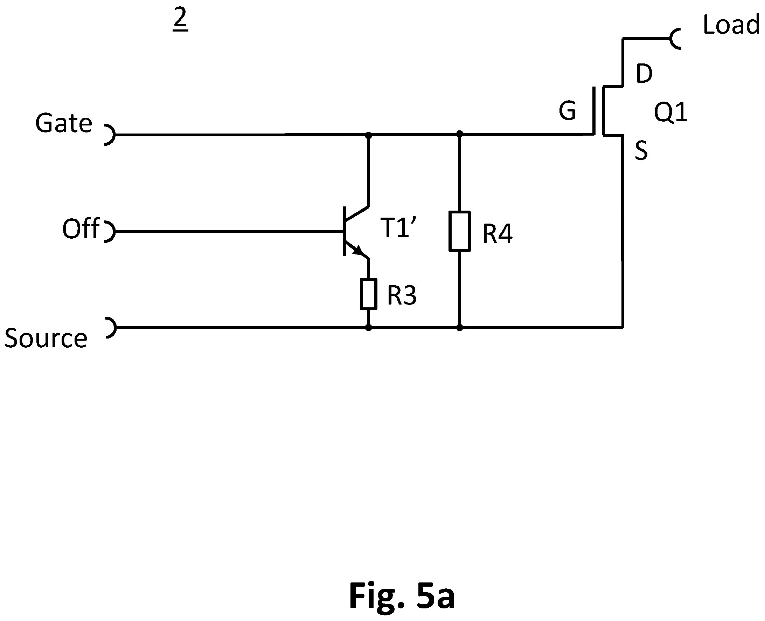

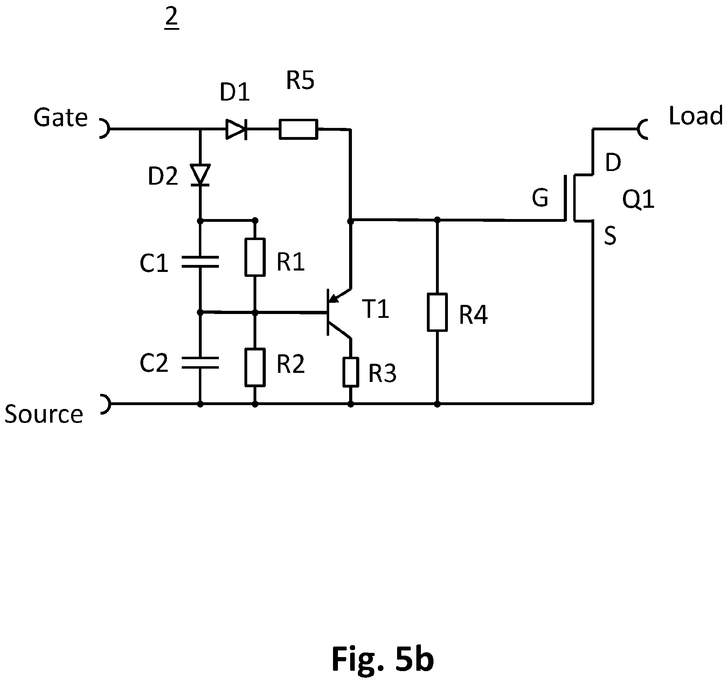

Figur 5 zeigt schematisch eine erfindungsgemässe erste Variante der Treiberstufe 2 für jeweils die MOSFET 1223 des hinteren PCB 122 des Tasters 1. Der MOSFET Q1 umfasst ein Gate G, eine Source S und ein Drain D. Am Drain D ist die Last "Load" anschliessbar. Eine Parallelschaltung mit einem ersten Kondensator C1 und einem ersten Widerstand R1 ist zwischen der Basis eines bipolaren Transistors T1 und dem Gate G angeschlossen. Eine Parallelschaltung mit einem zweiten Kondensator C2 und einem zweiten Widerstand R2 ist zwischen der Basis des bipolaren Transistors T1 und der Source S angeschlossen. Der Emitter des bipolaren Transistors T1 ist am Gate G angeschlossen. Der Kollektor des bipolaren Transistors T1 ist über einen dritten Widerstand R3 an der Source S angeschlossen. Ein vierter Widerstand R4 ist zwischen Gate G und Source S angeschlossen. Der Wert des ersten Kondensators C1 kann beispielsweise 10nF betragen. Der Wert des zweiten Kondensators C2 kann beispielsweise eine Kapazität von 22nF aufweisen. Der Wert des ersten Widerstands R1 kann beispielsweise 30kOhm betragen. Der Wert des zweiten Widerstands R2 kann beispielsweise 100kOhm betragen. Der Wert des dritten Widerstands R3 kann beispielsweise 4.7Ohm betragen. Der Wert des vierten Widerstands R4 kann beispielsweise 36kOhm betragen. Der MOSFET Q1 ist beispielsweise vom Typ STI33N65M2. Der bipolare Transistor T1 ist beispielsweise vom Typ BC857C.

Fig. 5a illustriert schematisch eine erfindungsgemäße zweite Variante der Treiberstufe 2. Gegenüber der in Fig. 5 gezeigten Treiberstufe sind die Widerständer R1, R2 und die Kondensatoren C1, C2 entfernt und der PNP Transistor T1 ist durch einen NPN Transistor T1' ersetzt. Die Basis des Transistor T1' kann direkt an einen Ausgang Off eines uController (Mikro-Controller) angeschlossen sein, ggf. über einen Widerstand mit z.B. 4.7kOhm. Der uController kann als gnd (Ground) die Source verwenden. Der uController kann eingerichtet sein, dass beispielsweise 20ms nachdem der Ausgang ausgeschaltet wurde der Ausgang Off angesteuert wird (z.B. auf 3.3V gesetzt wird) und somit der MOSFET Q1 verriegelt wird.

Fig. 5b illustriert schematisch eine Ausführungsform der erfindungsgemässen Treiberstufe 2. Gegenüber der in Fig. 5 gezeigten Treiberstufe ist das Gate G über einen fünften Widerstand R5, eine erste Diode D1 in Sperrrichtung, eine zweite Diode D2 in Durchlassrichtung und über die Parallelschaltung mit dem ersten Kondensator C1 und dem ersten Widerstand R1 mit der Basis des bipolaren Transistors T1 verbunden. Der Wert des fünften Widerstands R5 kann beispielsweise 47kOhm betragen. Die Dioden D1, D2 sind beispielsweise vom Typ BAW56 7 F.

Die Treiberstufe 2 hat eine dynamische Impedanz. Werden dimmbare Lichtquellen gemäss Phasenabschnittsteuerung oder Phasenanschnittsteuerung betrieben, werden das Gates des MOSFET Q1 automatisch mit einer hohen Impedanz angesteuert, was zu einer tiefen slew-rate und somit zu einer Reduktion des Störspektrums führt. Zusätzliche Entstördrosseln werden überflüssig, was eine sehr kompakte Bauform des Dimmers ermöglicht. Sobald der MOSFET Transistor Q1 vollständig sperrt, reduziert sich die Impedanz des Gate-Treibers automatisch auf wenige Ohm und verhindert damit ein selbstständiges Leiten des MOSFET Q1 durch Spannungsspitzen wie sie vor allem beim Schalten von induktiven Verbrauchern wie elektrischen Motoren erzeugt werden. Die Treiberstufe 2 für den MOSFET Q1 kann somit sowohl Lichtquellen mit geringem Störspektrum dimmen als auch induktive Lasten zuverlässig ein und ausschalten. Somit ist gleichermassen ein Dimmen von elektrischen Lichtquellen als auch das Betreiben von elektrischen Motoren (Storen) ermöglicht, wobei das Volumen der elektrischen Komponenten gering gehalten werden kann und somit ein Taster 1 ermöglicht ist, welcher in einer für Gebäudeinstallationen vorgegebenen Grösse hergestellt werden kann und sowohl für elektrische Lichtquellen als auch für elektrische Motoren geeignet ist. Die Funktionsweise kann auch folgendermassen beschrieben werden: Würde das Gate des MOSFET lediglich über den für den Dimmer notwendigen ziemlich grossen Widerstand auf Source gezogen, würden Spannungsspitzen, welche auf dem Netz vagabundieren durch die Miller-Kapazität auf das Gate übertragen und den Transistor zum Leiten bringen. Eine Verzögerungsschaltung (Tiefpass) "verriegelt" nun das Gate kurze Zeit nachdem es hochohmig auf Source gezogen wurde, indem der zusätzliche bipolare Transistor T1 das Gate niederohmig auf Source klemmt.

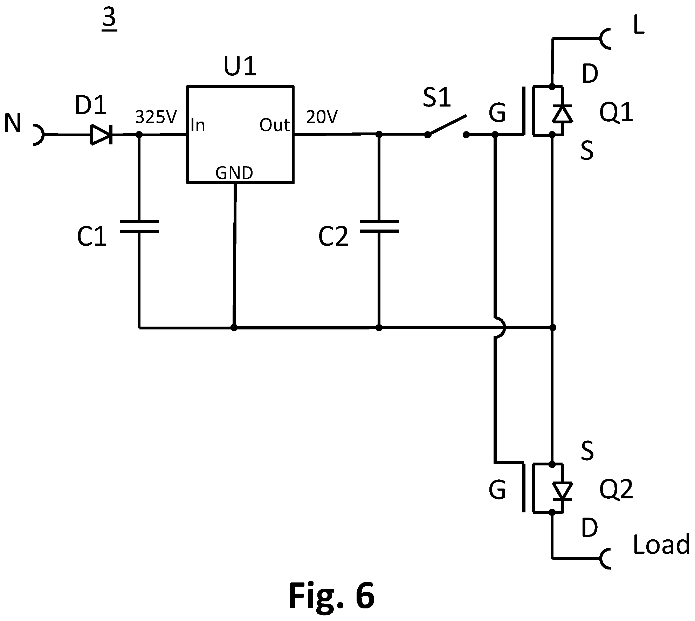

Figur 6 zeigt schematisch eine erfindungsgemässe Gatespannungsversorgung 3 zur Erzeugung einer für die Ansteuerung von MOSFET Q1, Q2 erforderlichen Gate-Source Spannung. Source S eines ersten MOSFET Q1 und eines zweiten MOSFET Q2 sind miteinander verbunden. Gate G des ersten MOSFET Q1 und des zweiten MOSFET Q2 sind miteinander verbunden. Gate G der MOSFET Q1, Q2 ist über den Schalter S1 mit dem Ausgang Out eines Linearreglers U1 verbunden. Nullleiter N ist über eine Diode D1 mit dem Eingang In des Linearreglers U1 verbunden. Ein Kondensator C1 verbindet den Eingang In des Linearreglers U1 mit Source S der MOSFET Q1, Q2. Ein Kondensator C2 verbindet den Ausgang Out des Linearreglers U1 mit Source S der MOSFET Q1, Q2. Die Erde GND des Linearreglers U1 ist mit Source der MOSFET Q1, Q2 verbunden. Der Wert des Kondensators C1 beträgt beispielsweise 220nF 450V. Der Wert des Kondensators C2 beträgt beispielsweise 10uF 35V. Der Linearregler U1 ist beispielsweise vom Typ LR8N8-G. Die Diode D1 ist beispielsweise vom Typ DA2JF8100L.

Um MOSFET Transistoren anzusteuern wird eine 10V Gate-Source Spannung benötigt. Diese Spannung wird üblicherweise durch ein galvanisch getrenntes Netzteil geliefert. Eine andere Möglichkeit ist ein Signaltransformator zwischen Ansteuerung und Gate. Die Ansteuerung erfolgt mit einem Rechtecksignal, welches durch den Transformator galvanisch getrennt, dann gleichgerichtet und geglättet wird. Die Ansteuerung liefert somit die Energie für die Gateladung direkt via den Transformator. Eine andere Möglichkeit ist eine kleine Photovoltaik-Zelle (Optokoppler mit LED und PV-Zelle, PV: Photo Voltaik) um die galvanisch getrennte Gate-Spannung zu erzeugen. Figur 6 zeigt eine erfindungsgemässe Ansteuerschaltung 3, welche deutlich einfacher aufgebaut ist und gänzlich auf grosse und teure Bauteile wie Transformatoren verzichtet. Dies ermöglicht, den Taster 1 in einer vorgegebenen Grösse herzustellen, welche für eine Gebäudeinstallation geeignet ist. Weiter schaltet die Ansteuerschaltung 3 im Gegensatz zu den bekannten Lösungen sehr schnell und ermöglicht somit ein verzögerungsfreies Ansteuern der MOSFET Q1, Q2, was für synchrone Schaltungen (wie zum Beispiel Dimmer) unerlässlich ist. Die Ansteuerschaltung 3 nutzt lediglich die in den MOSFET Q1, Q2 vorkommenden parasitären Body-Dioden als Gleichrichterdioden. Ein Kondensator C1 wird via Body-Dioden und eine zusätzliche Gleichrichterdiode D1 gegen den Nullleiter N auf 325V geladen. Diese Spannung wird mit einem Linearregler U1 auf 20V heruntergeregelt und mit dem zweiten Kondensator C2 geglättet. Diese Spannung ist bereits in Bezug auf die Source S der MOSFET Q1, Q2 und kann direkt zur Ansteuerung des Gates verwendet werden.

## Patentansprüche

1. Ein Taster (1) für eine Gebäudeinstallation, wobei der Taster (1) eine für die Gebäudeinstallation geeignete vorgegebene Grösse aufweist und elektrische Anschlüsse (1224) aufweist, an welche wahlweise eine elektrische Lichtquelle oder ein elektrischer Motor anschliessbar sind, wobei der Taster ausgebildet ist zum Ein-/Ausschalten und Dimmen der anschliessbaren Lichtquelle und zum Betreiben des anschliessbaren elektrischen Motors, **dadurch gekennzeichnet, dass**
die vorgegebene Grösse definiert ist durch einen maximalen Durchmesser von 62mm und eine maximale Einbautiefe von 52mm, wobei
der Taster (1) mindestens einen MOSFET (Q1) aufweist, für den eine Treiberstufe (2) mit einer dynamischen Impedanz vorgesehen ist, um wahlweise mindestens eine Lichtquelle ein-/auszuschalten und allenfalls zu dimmen und mindestens einen elektrischen Motor in mindestens einer Richtung zu betreiben, wobei die Treiberstufe (2) entweder
a) eine Parallelschaltung mit einem ersten Kondensator (C1) und einem ersten Widerstand (R1) welche zwischen der Basis eines bipolaren Transistors (T1) und dem Gate (G) des MOSFET (Q1) angeschlossen ist, eine Parallelschaltung mit einem zweiten Kondensator (C2) und einem zweiten Widerstand (R2) welche zwischen der Basis des bipolaren Transistors (T1) und der Source (S) des MOSFET angeschlossen ist, wobei der Emitter des bipolaren Transistors (T1) am Gate (G) des MOSFET angeschlossen ist, wobei der Kollektor des bipolaren Transistors (T1) über einen dritten Widerstand (R3) an der Source (S) des MOSFET (Q1) angeschlossen ist, und einen vierten Widerstand (R4) welcher zwischen Gate (G) und Source (S) des MOSFET angeschlossen ist, umfasst,
oder
b) einen programmierten Mikro-Controller (OFF) derart eingerichtet, dass durch Ansteuerung des Ausgangs des Mikro-Controller (OFF) der MOSFET (Q1) programmiert verriegelbar ist, umfasst, wobei ein bipolarer NPN Transistor (T1') dessen Basis an einen Ausgang des Mikro-Controller (OFF) angeschlossen ist, wobei der Emitter des bipolaren Transistors (T1') am Gate (G) des MOSFET (Q1) angeschlossen ist, wobei der Kollektor des bipolaren Transistors (T1') über einen dritten Widerstand (R3) an der Source (S) des MOSFET (Q1) angeschlossen ist, und ein vierter Widerstand (R4) zwischen Gate (G) und Source (S) des MOSFET angeschlossen ist.

2. Der Taster (1) nach Anspruch 1, wobei die Treiberstufe (2) gemäss Variante a) einen fünften Widerstand (R5) aufweist und das Gate (G) über den fünften Widerstand (R5), eine erste Diode (D1) in Sperrrichtung, eine zweite Diode (D2) in Durchlassrichtung und über die Parallelschaltung mit dem ersten Kondensator (C1) und dem ersten Widerstand (R1) mit der Basis des bipolaren Transistors (T1) verbunden ist.

3. Der Taster (1) nach einem der vorhergehenden Ansprüche, wobei sich die elektrische Lichtquelle bezieht auf eine nur schaltbare Lichtquelle oder auf eine sowohl schaltbare als auch dimmbare Lichtquelle.

4. Der Taster (1) nach einem der vorhergehenden Ansprüche, wobei sich der elektrische Motor auf einen elektrischen Motor bezieht für den Antrieb von Storen, von Jalousien, von Sonnenstoren, von Rollläden, von Fensterläden, von Beschattungsanlagen, von Toren, von Türen und/oder von Fenstern.

5. Der Taster (1) nach einem der vorhergehenden Ansprüche, wobei eine Heizungssteuerung an die elektrischen Anschlüsse anschliessbar ist und der Taster ausgebildet ist, dem anschliessbaren Heizungsventil einen Thermostaten zur Verfügung zu stellen.

6. Der Taster (1) nach einem der Ansprüche 1 bis 5, weiter umfassend eine drahtlose Schnittstelle gemäss einem IEEE-802.11-Standard, einem Bluetooth Standard, einem Bluetooth Low Energy Standard, einem ZigBee Standard, und/oder einem Z-Wave Standard.

7. Der Taster (1) nach einem der Ansprüche 1 bis 6, weiter umfassend einen Bewegungssensor, einen Helligkeitssensor, einen Temperatursensor, einen Luftqualitätssensor, einen Feuchtigkeitssensor und/oder einen Lautstärkesensor.

8. Der Taster nach einem der Ansprüche 1 bis 7, wobei der Taster (1) insgesamt acht MOSFET aufweist die eingerichtet sind, um wahlweise bis zu vier Lichtquellen ein-/auszuschalten und allenfalls zu dimmen und bis zu zwei elektrische Motoren zu betreiben.

9. Der Taster (1) nach einem der vorhergehenden Ansprüche, weiter umfassend eine Ansteuerschaltung (3) zur Erzeugung einer Gate-Source Spannung für mindestens einen MOSFET, die Ansteuerschaltung (3) umfassend: eine Diode (D1) welche im Zusammenwirken mit einer Body-Diode des mindestens einen MOSFET eine gleichgerichtete Spannung zur Ansteuerung eines Linearreglers (U1) erzeugt, wobei der Linearregler (U1) eine Spannung zur Ansteuerung des mindestens einen MOSFET zur Verfügung stellt.

## Claims

1. A push-button switch (1) for a building installation, wherein the push-button switch (1) has a predetermined size suitable for the building installation and electrical terminals (1224) to which either an electric light source or an electric motor can be connected, wherein the push-button switch is designed to switch the connectable light source on/off and dim it, and to operate the connectable electric motor, **characterized in that** the predetermined size is defined by a maximum diameter of 62 mm and a maximum installation depth of 52 mm, wherein the push-button switch (1) comprises at least one MOSFET (Q1) for which a driver stage (2) with a dynamic impedance is provided to selectively switch at least one light source on/off and, if necessary, dim it, and to operate at least one electric motor in at least one direction, wherein the driver stage (2) comprises either
a) a parallel circuit comprising a first capacitor (C1) and a first resistor (R1) connected between the base of a bipolar transistor (T1) and the gate (G) of the MOSFET (Q1), a parallel connection comprising a second capacitor (C2) and a second resistor (R2) connected between the base of the bipolar transistor (T1) and the source (S) of the MOSFET, wherein the emitter of the bipolar transistor (T1) is connected to the gate (G) of the MOSFET, wherein the collector of the bipolar transistor (T1) is connected to the source (S) of the MOSFET (Q1), and a fourth resistor (R4) connected between the gate (G) and the source (S) of the MOSFET, or
b) a programmable microcontroller (OFF) configured such that the MOSFET (Q1) can be programmatically locked by controlling the output of the microcontroller (OFF), wherein a bipolar NPN transistor (T1') whose base is connected to an output of the microcontroller (OFF), wherein the emitter of the bipolar transistor (T1') is connected to the gate (G) of the MOSFET (Q1), wherein the collector of the bipolar transistor (T1') is connected via a third resistor (R3) to the source (S) of the MOSFET (Q1), and a fourth resistor (R4) is connected between the gate (G) and source (S) of the MOSFET.

2. The push-button switch (1) according to claim 1, wherein the driver stage (2) according to variant a) includes a fifth resistor (R5) and the gate (G) is connected via the fifth resistor (R5), a first diode (D1) in reverse bias, a second diode (D2) in forward bias, and via the parallel connection with the first capacitor (C1) and the first resistor (R1) to the base of the bipolar transistor (T1).

3. The push-button switch (1) according to one of the preceding claims, wherein the electric light source refers to a light source that can only be switched on or off, or to a light source that can be both switched on or off and dimmed.

4. The push-button switch (1) according to one of the preceding claims, wherein the electric motor refers to an electric motor for driving awnings, blinds, sunshades, roller shutters, window shutters, shading systems, gates, doors, and/or windows.

5. The push-button switch (1) according to one of the preceding claims, wherein a heating control unit can be connected to the electrical terminals and the push-button switch is configured to provide a thermostat to the connectable heating valve.

6. The push-button switch (1) according to any one of claims 1 to 5, further comprising a wireless interface conforming to an IEEE 802.11 standard, a Bluetooth standard, a Bluetooth Low Energy standard, a ZigBee standard, and/or a Z-Wave standard.

7. The button (1) according to any one of claims 1 to 6, further comprising a motion sensor, a light sensor, a temperature sensor, an air quality sensor, a humidity sensor, and/or a sound level sensor.

8. The control unit according to any one of claims 1 to 7, wherein the control unit (1) comprises a total of eight MOSFETs configured to selectively turn on and off, and optionally dim, up to four light sources and to drive up to two electric motors.

9. The push-button switch (1) according to one of the preceding claims, further comprising a drive circuit (3) for generating a gate-source voltage for at least one MOSFET, the drive circuit (3) comprising: a diode (D1) which, in cooperation with a body diode of the at least one MOSFET, generates a rectified voltage for driving a linear regulator (U1), wherein the linear regulator (U1) provides a voltage for driving the at least one MOSFET.

## Revendications

1. Un bouton-poussoir (1) destiné à une installation de bâtiment, ledit bouton-poussoir (1) présentant une taille prédéfinie adaptée à l'installation de bâtiment et comportant des bornes électriques (1224) auxquelles peuvent être raccordés au choix une source lumineuse électrique ou un moteur électrique, le bouton-poussoir étant conçu pour allumer, éteindre et varier l'intensité de la source lumineuse raccordable et pour actionner le moteur électrique raccordable, **caractérisé en ce que** la taille prédéfinie est définie par un diamètre maximal de 62 mm et une profondeur d'encastrement maximale de 52 mm, le bouton-poussoir (1) comportant au moins un MOSFET (Q1) pour lequel un étage d'attaque (2) à impédance dynamique est prévu pour, au choix, allumer/éteindre et, le cas échéant, varier l'intensité d'au moins une source lumineuse et pour faire fonctionner au moins un moteur électrique dans au moins une direction, l'étage d'attaque (2) étant soit
a) un montage en parallèle avec un premier condensateur (C1) et une première résistance (R1) qui sont connectés entre la base d'un transistor bipolaire (T1) et la grille (G) du MOSFET (Q1), un montage en parallèle avec un deuxième condensateur (C2) et une deuxième résistance (R2) qui est connecté entre la base du transistor bipolaire (T1) et la source (S) du MOSFET, l'émetteur du transistor bipolaire (T1) étant connecté à la grille (G) du MOSFET, le collecteur du transistor bipolaire (T1) étant connecté à la source (S) du MOSFET (Q1), et une quatrième résistance (R4) qui est connectée entre la grille (G) et la source (S) du MOSFET, ou
b) un microcontrôleur programmé (OFF) agencé de telle sorte que, par la commande de la sortie du microcontrôleur (OFF), le MOSFET (Q1) puisse être verrouillé de manière programmée, un transistor bipolaire NPN (T1') dont la base est connectée à une sortie du microcontrôleur (OFF), l'émetteur du transistor bipolaire (T1') étant connecté à la grille (G) du MOSFET (Q1), le collecteur du transistor bipolaire (T1') est connecté à la source (S) du MOSFET (Q1) via une troisième résistance (R3), et une quatrième résistance (R4) est connectée entre la grille (G) et la source (S) du MOSFET.

2. Le bouton-poussoir (1) selon la revendication 1, dans lequel l'étage d'attaque (2) selon la variante a) comporte une cinquième résistance (R5) et la grille (G) est connectée, via la cinquième résistance (R5), une première diode (D1) en sens inverse, une deuxième diode (D2) en sens direct et via le montage en parallèle du premier condensateur (C1) et de la première résistance (R1) à la base du transistor bipolaire (T1).

3. Le bouton-poussoir (1) selon l'une des revendications précédentes, la source lumineuse électrique se référant à une source lumineuse uniquement commutable ou à une source lumineuse à la fois commutable et gradable.

4. Le bouton-poussoir (1) selon l'une des revendications précédentes, le moteur électrique se rapportant à un moteur électrique destiné à l'entraînement de stores, de jalousies, de stores pare-soleil, de volets roulants, de volets, de systèmes d'ombrage, de portails, de portes et/ou de fenêtres.

5. Le bouton-poussoir (1) selon l'une des revendications précédentes, dans lequel un système de commande de chauffage peut être raccordé aux bornes électriques et le bouton-poussoir est conçu pour fournir un thermostat à la vanne de chauffage raccordable.

6. Le bouton-poussoir (1) selon l'une des revendications 1 à 5, comprenant en outre une interface sans fil conforme à une norme IEEE 802.11, à une norme Bluetooth, à une norme Bluetooth Low Energy, à une norme ZigBee et/ou à une norme Z-Wave.

7. Le bouton-poussoir (1) selon l'une des revendications 1 à 6, comprenant en outre un capteur de mouvement, un capteur de luminosité, un capteur de température, un capteur de qualité de l'air, un capteur d'humidité et/ou un capteur de niveau sonore.

8. Le bouton-poussoir selon l'une des revendications 1 à 7, dans lequel le bouton-poussoir (1) comporte au total huit MOSFET qui sont configurés pour allumer et éteindre, et le cas échéant varier l'intensité, jusqu'à quatre sources lumineuses, et pour commander jusqu'à deux moteurs électriques.

9. Le bouton-poussoir (1) selon l'une des revendications précédentes, comprenant en outre un circuit de commande (3) destiné à générer une tension grille-source pour au moins un MOSFET, le circuit de commande (3) comprenant : une diode (D1) qui, en coopération avec une diode de corps dudit au moins un MOSFET, génère une tension redressée pour commander un régulateur linéaire (U1), le régulateur linéaire (U1) fournissant une tension pour commander ledit au moins un MOSFET.
